# EUROPEAN PATENT APPLICATION

(11) **EP 1 925 898 A1**
(43) Date of publication of application: **28.05.2008**
(21) Application number: 05783400.4
(22) Date of filing: 13.09.2005
(51) Int. Cl.: F28F 1/00, H01L 23/36, H01L 23/467, F28F 1/40, F28F 13/12

(54) **HEAT SINK**

(71) Applicant: MITSUBISHI DENKI KABUSHIKI KAISHA, Chiyoda-ku, Tokyo 100-8310 (JP)
(72) Inventor: IPPOUSHI, Shigetoshi, Chiyoda-ku, Tokyo 1008310 (JP); OGUSHI, Tetsuro, Chiyoda-ku, Tokyo 1008310 (JP); HAGA, Seiji, Chiyoda-ku, Tokyo 1008310 (JP); KIMURA, Toru, Chiyoda-ku, Tokyo 1008310 (JP); YAMADA, Akira, Chiyoda-ku, Tokyo 1008310 (JP); YAMABUCHI, Hiroshi, Chiyoda-ku, Tokyo 1008310 (JP); MURAHASHI, Akihiro, Chiyoda-ku, Tokyo 1008310 (JP); OKAYAMA, Hideo, Chiyoda-ku, Tokyo 1008310 (JP); UEHARA, Nobuaki, Chiyoda-ku, Tokyo 1008310 (JP)
(74) Representative: Popp, Eugen
(86) International application number: PCT/JP2005/016796
(87) International publication number: WO 2007/032056

(57) **Abstract**

The present invention relates to a heat sink, provided with a heat-transfer container (3) incorporating a flow path (2) through which a cooling fluid (11) flows, for cooling a heating element (6) in contact with the heat-transfer container (3), by means of the cooling fluid (11) that flows through the flow path (2). The flow path (2) includes a first cross-sectional portion that becomes narrower as the distance between a given point therein and a side, of the heat-transfer container (3), which makes contact with the heating element (6) becomes longer in a direction perpendicular to the direction in which the cooling fluid (11) flows and a second cross-sectional portion that is approximately constant in the direction perpendicular to the direction in which the cooling fluid (11) flows, and the first cross-sectional portion and the second cross-sectional portion alternately continue in the direction in which the cooling fluid (11) flows; therefore, by causing a three-dimensional flow, the heat-transfer properties can be enhanced with a simplified structure.

## Description

### Technical Field

The present invention relates to a heat sink having a heat-radiation structure for cooling a heating element formed with electronic components or the like, and more particularly to a heat sink having a heat-radiation structure for carrying out cooling by use of forced convection.

### Background Art

A conventional heat sink is configured in such a way that the flow of a cooling fluid is stirred by pin-shaped fins so that, the heat-transfer performance (heat radiation) is enhanced in comparison with a heat-radiation member provided with a continuous fin (e.g., refer to Patent. Document 1).

[Patent Document 1]
Japanese Patent Application Laid-Open No. 2004-63898 (Page 6 and FIG. 8)

### Disclosure of the Invention

### Problems that the Invention is to Solve

A conventional heat sink is configured in such a way that pin-shaped fins are provided in a two-dimensional flow to utilize the turbulence effect so that the heat-transfer performance is enhanced; however, in recent years, it has been a problem that the heat-transfer performance such that an increasing amount of heat generated in an electronic apparatus is sufficiently radiated cannot be obtained.

The present invention has been implemented in order to solve the foregoing problem of the conventional technique; the objective of the present invent.ion is to provide a heat sink in which a three-dimensional flow of a cooling fluid is caused so that the heat-transfer efficiency is enhanced with a simpler structure.

### Means for Solving the Problems

A heat sink according to the present invention is provided with a heat-transfer container incorporating a flow path through which a cooling fluid flows; the heat sink cools a heating element in contact with the heat-transfer container, by means of the cooling fluid that flows through the flow path. The flow path includes a first cross-sectional portion that becomes narrower as the distance between a given point therein and a side, of the heat-transfer container, which makes contact with the heating element becomes longer in a direction perpendicular to the direction in which the cooling fluid flows and a second cross-sectional portion that is approximately constant in the direction perpendicular to the direction in which the cooling fluid flows; the first cross-sectional portion and the second cross-sectional portion alternately continue in the direction in which the cooling fluid 1 flows.

Moreover, in a heat sink according to the present invention, the shape of the first cross-sectional portion of the flow path is formed based on one or more protrusions provided inside the heat-transfer container.

Still moreover, in a heat sink according to the present invent.ion, the protrusion has at least one of the shapes of an approximate cone, an approximate multi-sided pyramid, an approximate sphere, and a hemisphere.

Still moreover, in a heat sink according to the present invention, a fin extending in the direction in which the cooling fluid flows is provided on the inner surface of the heat-transfer container.

Furthermore, in a heat sink according to the present invent.ion, the protrusions are arranged in plurality on a substrate provided in the heat-transfer container.

Still furthermore, in a heat sink according to the present invention, the substrate is disposed inside the heat-transfer container in such a way as to divide the flow path into two flow paths, the protrusions are arranged on both sides of the substrate, and the heat-transfer container is configured in such a way that a side thereof in contact with one of the divided flow paths and a side thereof in contact with the other of the divided flow paths make contact with respective heating elements.

Moreover, a heat sink according to the present invention is provided with a heat-transfer container having a flow path through which a cooling fluid flows; the heat sink cools a heating element in contact with the heat-transfer container, by means of the cooling fluid that flows through the flow path. The heat-transfer container has an opening for bringing the cooling fluid into direct contact with the heating element; the flow path includes a first, cross-sectional portion that becomes narrower as the distance between a given point therein and a side, of the heat-transfer container, which makes contact with the heating element becomes longer in a direction perpendicular to the direction in which the cooling fluid flows and a second cross-sectional portion that is approximately constant in the direction perpendicular to the direction in which the cooling fluid flows; the first cross-sectional portion and the second cross-sectional portion alternately continue in the direction in which the cooling fluid 1 flows.

Still moreover, in a heat sink according to the present invention, a fin extending in the direction in which the cooling fluid flows is provided on a side, of the heating element, which makes contact with the cooling fluid.

### Advantage of the Invention

A heat sink according to the present invention is configured in such a way that the flow path thereof includes a first cross-sectional portion that becomes narrower as the distance between a given point therein and a side, of the heat-transfer container, which makes contact with the heating element becomes longer in a direction perpendicular to the direction in which the cooling fluid flows and a second cross-sectional portion that is approximately constant in the direction perpendicular to the direction in which the cooling fluid flows, and the first cross-sectional portion and the second cross-sectional portion alternately continue in the direction in which the cooling fluid 1 flows; therefore, a three-dimensional flow of the cooling fluid is caused, whereby the heat-transfer properties can be enhanced with a simplified structure.

Moreover, in a heat sink according to the present invention, the shape of the first cross-sectional portion of the flow path is formed based on one or more protrusions provided inside the heat-transfer container; therefore, the three-dimensional flow of the cooling fluid is caused with a simplified structure, whereby the heat-transfer properties can be enhanced.

Still moreover, in a heat sink according to the present invention, a fin extending in the direction in which the cooling fluid flows is provided on the inner surface of the heat-transfer container; therefore, heat can more effectively be radiated.

Furthermore, in a heat sink according to the present invention, the protrusions are arranged in plurality on the substrate provided in the heat-transfer container; therefore, by inserting the substrate into the heat-transfer container, the protrusions can simply be arranged inside the heat-transfer container.

Still furthermore, in a heat sink according to the present invention, the substrate is disposed inside the heat-transfer container in such a way as to divide the flow path into two flow paths, the protrusions are arranged on both sides of the substrate, and the heat-transfer container is configured in such a way that a side thereof in contact with one of the divided flow paths and a side thereof in contact with the other of the divided flow paths make contact with respective heating elements; therefore, a plurality of heating elements can concurrently and efficiently be cooled.

Moreover, a heat sink according to the present invention is provided with a heat-transfer container having a flow path through which a cooling fluid flows; the heat sink cools a heating element in contact with the heat-transfer container, by means of the cooling fluid that flows through the flow path. The heat sink is configured in such a way that the heat-transfer container has an opening for bringing the cooling fluid into direct contact with the heating element; the flow path includes a first cross-sectional portion that becomes narrower as the distance between a given point therein and a side, of the heat-transfer container, which makes contact with the heating element becomes longer in a direction perpendicular to the direction in which the cooling fluid flows and a second cross-sectional portion that is approximately constant in the direction perpendicular to the direction in which the cooling fluid flows; and the first cross-sectional portion and the second cross-sectional portion alternately continue in the direction in which the cooling fluid 1 flows. As a result, because the heating element is brought into direct contact with the cooling fluid so as to be cooled, cooling can more efficiently be carried out.

Still moreover, in a heat sink according to the present invention, a fin extending in the direction in which the cooling fluid flows is provided on a side, of the heating element, which makes contact with the cooling fluid; cooling can further efficiently be carried out.

### Best Mode for Carrying Out the Invention

### Embodiment 1

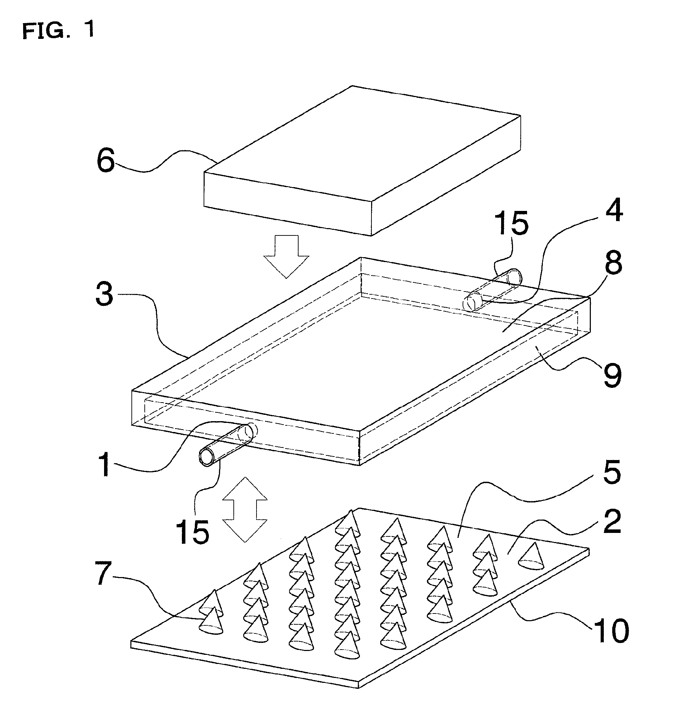

FIG. 1 is an exploded perspective view for explaining a heat sink according to Embodiment 1 of the present invention.

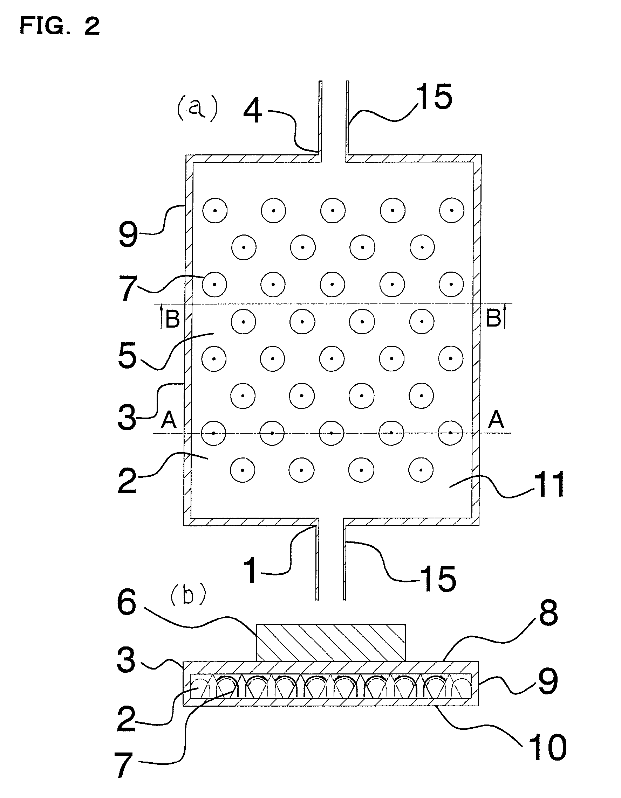

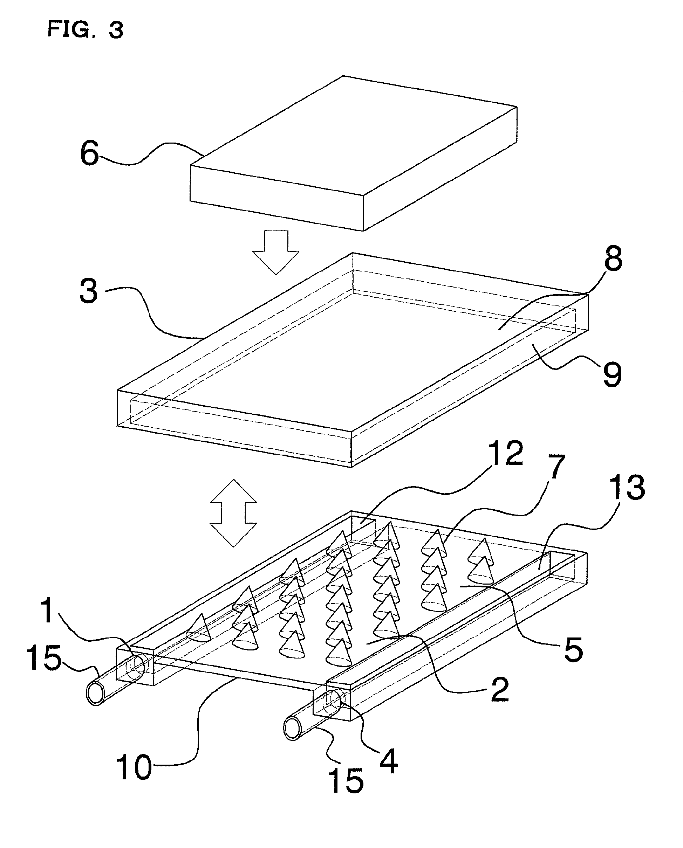

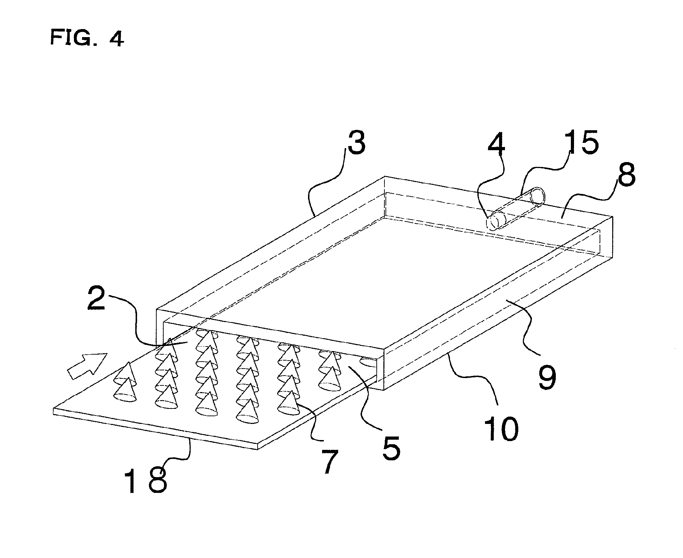

FIG. 2 is a cross-sectional view of the heat sink in FIG. 1; FIGS. 1(a) and 1(b) are a transverse cross-sectional view and a longitudinal cross-sectional view, respectively. Fig. 3 is an exploded perspective view for explaining a variant example of Embodiment. 1; FIG. 4 is a perspective view for explaining another variant example of Embodiment 1. In addition, in the figures including those for other embodiments, the same reference characters denote the same or equivalent portions.

In FIGS. 1 and 2, a heating element 6, such as an electronic component, which is the cooling subject of a heat sink is disposed thermally coupled with a base 8 of a heat-transfer container 3. The base 8 is molded integrally with four sidewalls 9. In the heat-transfer container 3, a cooling-fluid inlet 1 and a cooling-fluid outlet 4 are provided; a flow path 2 is formed inside the heat-transfer container 3. The cooling-fluid inlet 1 and the cooling-fluid outlet 4 are connected to a fluid-flow pipe 15. A lid 10 is fixed to one side, of the heat-transfer container 3, which faces the base 8 thereof; on the lid 10, conical (approximately cone-shaped) protrusions 7 exposed toward the inside of the heat-transfer container 3 are provided in a predetermined arrangement. The protrusions 7 play a role of facilitating turbulence in a cooling fluid 11 that flows inside the heat-transfer container 3. The cooling-fluid inlet 1, the cooling-fluid outlet 4, and the heat-transfer container 3 form a continuous fluid-flow path 5.

The cross sections, of the flow paths 2, in a direction perpendicular to the direction in which the cooling fluid 11 as a refrigerant flows are arranged in such a way that first cross-sectional portions each of which, due to the existence of the protrusion 7, becomes narrower as a given viewing point in the first cross-sectional portion moves away from the base 8, on which the heating element 6 is mounted, toward the lid 10 and second cross-sectional portions each of which, i.e., the width of the flow path 2, due to no existence of the protrusion 7, is constant even though a given viewing point in the second cross-sectional portion moves away from the base 8, on which the heating element 6 is mounted, toward the lid 10 alternately continue in the direction in which the cooling fluid 11 flows. As a result, the flow path 2 is configured in such a way that approximately trapezoidal flow paths the width of each of which gradually decreases, in the height direction (thickness direction) of the heat-transfer container 3, from the vicinity of the base 8 on which the heating element 6 is mounted and flow paths the width of each of which is approximately constant in the height direction of the heat-transfer container 3 are sequentially coupled in the direction in which the cooling fluid 11 flows. The heat-transfer container serves as a main body of the heat sink.

The heat sink is a heat-radiation structure configured in such a way that the cooling-fluid inlet 1 for inputting the low-temperature cooling fluid 11, the heat-transfer container 3 with which the heating element 6 is thermally coupled and inside of which the flow path 2 is formed, and the cooling-fluid outlet 4 for outputting the cooling fluid 11 that has absorbed heat from the heating element 6 and has become high-temperature form the continuous fluid-flow path 5. The foregoing heat sink is coupled with an unillustrated pump or fan, by the intermediary of a fluid-flow pipe, and the cooling fluid 11 is made to flow in the heat sink, so that heat generated by the heating element 6 is radiated toward surroundings. Moreover, by coupling the heat sink with a heat-radiation device by means of an unillustrated fluid-flow pipe, a circulating fluid-flow loop may be formed; still moreover, a reservoir and a filter may be provided in midstream of the fluid-flow loop. In this case, the cooling fluid 11 circulates within the fluid-flow loop, the cooling fluid 11 transports heat generated by the heating element 6 to the heat-radiation device, and then the heat is radiated from the heat-radiation device toward the surroundings. In addition, a distribution header or a merging header may be provided in the heat-transfer container 3 so that the cooling fluid 11 flows more evenly within the flow path.

In Embodiment 1, the base 8 thermally coupled with the heating element 6 and the sidewall 9 are integrally molded; by combining the lid 10 with the integrated base 8 and the side wall 9, the heat-transfer container 3 is formed. However, the present invention is not necessarily limited t.hereto; the base 8, the sidewall 9, and the lid 10 may be separately produced and then combined, or the sidewall 9 and the lid 10 may be integrally molded and then combined with the base 8. Moreover, the base 8, part of the sidewall 9, and the lid 10 may be integrally molded, and then combined with the residual sidewall 9.

Next, the operation of the heat sink according to Embodiment 1 of the present invention will be explained. In FIGS. 1 and 2, the cooling fluid 11 inputted through the cooling-fluid inlet 1 to the heat-transfer container 3 travels to the cooling-fluid outlet 4, while avoiding the protrusions 7 provided on the lid 10 when passing through the flow path 2 formed of the base 8, the sidewall 9, and the lid 10. The protrusion 7 is pointed; therefore, in the passage section (A - A section in FIG. 2) where the protrusions 7 are arranged transversely, because the closer to the base 8 a given position is, the larger the passage-section area is and the more excellent the fluid-flow properties are, the cooling fluid 11 in the vicinity of the lid 10 moves toward the base 8, whereby the flow rate in the vicinity of the base 8 is increased. In contrast, in the passage sect.ion (B-B section in FIG. 2) which lies between the two lines of the protrusions 7 and in which no protrusion 7 is situated, because no obstacle exists, the fluid-flow properties are homogeneous in the passage section, whereby the speed distribution in the passage section tends to be homogenized.

Accordingly, when the passage section for the cooling fluid 11 changes from a passage section corresponding to the A-A sect.ion to a passage section corresponding to the B - B section, the cooling fluid 11 moves from the vicinity of the base 8, where the flow rate is high, toward the lid 10. Because the longitudinal travel (in the thickness direction of the heat sink) of the cooling fluid 11 and the transverse travel (in the width direction of the heat sink) due to the cooling fluid 11 traveling while avoiding the protrusions 7 are concurrently caused, three-dimensional travels of the cooling fluid 11 occur, thereby stirring the cooling fluid 11.

In other words, as indicated by the arrows in the transverse section in FIG. 2(b), the cooling fluid 11 that travels in the depth direction with respect to the paper plane collides with the roots of the protrusions 7 and then travels toward the base 8 along the slopes of the protrusions 7. After that, the cooling fluid 11 collides with the inner surface of the base 8 and travels in the middle portions between the protrusions 7; t.hen, swirling flows that travels toward the lid 10 are caused. In the case where the protrusions 7 illustrated are in a staggering arrangement, which is a predetermined arrangement, the swirling flow causes a flow that alternates its swirling direct.ion with respect to the main flow direction. In addition, although being unillustrated, in the case where the protrusions 7 are in a grid arrangement, which is a predetermined arrangement, a continuous swirling flow having the same flow direction is caused. As described above, the three-dimensional flow of the cooling fluid 11 is caused; the swirling flow and a stirring effect due to the collision of the cooling fluid 11 with the inner surface (the surface that makes contact with the flow path 2) of the base 8 enhance the heat-transfer properties on the inner surface of the base 8.

The base 8 that makes direct contact with the heating element 6 receives heat and becomes high-temperature, whereby the temperature difference between the cooling fluid 11 in the flow path 2 and the base 8 is produced; thus, the heat is transferred from the base 8 to the cooling fluid 11. The cooling fluid 11 becomes high-temperature and then outputted from the cooling-fluid outlet 4. Accordingly, while passing through the cooling-fluid inlet 1, the flow path 2 inside the heat-transfer container 3, the cooling-fluid outlet 4, and further the flow path 5, the cooling fluid 11 becomes high-temperature, and then the high-temperature cooling fluid 11 is outputted from the cooling-fluid outlet 4.

As described above, in the heat sink according to Embodiment 1 of the present invention, the cone-shaped protrusions 7 cause the three-dimensional flow of the cooling fluid 11; thus, the forced-convection heat transfer due to the flow of the cooling fluid 11 inside the heat sink, the sensible heat change in the cooling fluid 11, the swirling flow, in the flow path 2, which causes a three-dimensional flow, and the stirring effect due to the collision enable heat to be efficiently radiated from the heating element 6 to the outside of the heat sink.

In the case of a conventional finless heat sink in which no fin is provided in the flow path of the heat.-transfer container, a cooling fluid linearly (in a one-dimensional manner) travels from the cooling-fluid inlet to the cooling-fluid outlet.; therefore, a relatively thick temperature boundary layer is formed in the vicinity of the inner surface of the base, whereby the heat characteristics are deteriorated. In addition, in the case of a conventional straight-fin heat sink in which a plurality of tabular fins are provided in the flow path of the heat-transfer container, the heat-transfer area in which the base and the cooling fluid make contact with each other increases, whereby the heat-transfer properties are enhanced; even in this case, however, a relatively thick temperature boundary layer is formed in the vicinity of the heat-transfer surface, whereby the effect that enhances the heat characteristics becomes relatively small. In addition, the fin here denotes a fin that has a function of radiating heat from the heating element 6 to the cooling fluid 11.

Moreover, in the case of a conventional pin-fin heat sink in which a plurality of pins are provided in the flow path of the heat-transfer container, the heat-transfer area in which the base and the cooling fluid make contact with each other increases and a two-dimensional flow is produced because the cooling fluid avoids the pins, whereby the heat-transfer properties are enhanced to some extent; however, the product.ion thereof is difficult and the production costs become high. Additionally, in general, pin-fin heat sinks are produced through die-casting; however, because, in the case where a pin-fin heat sink is produced through die-casting, the heat conductivity of the heat-sink material is low, the thermal-diffusion properties of the base unit and the fin efficiency of the fin unit are lowered, whereby the heat characteristics of the heat sink are deteriorated. Moreover, in producing the pin-fin heat sink, it is required to provide a draft angle to some extent (1.5° to 2°); because this draft angle makes the passage-section area in the vicinity of the base small, the cooling fluid inside the flow path is likely to pass in the vicinity of the lid, whereby the heat-transfer properties are deteriorated. In addit.ion, it is normally considered that the larger the draft angle is, the more the heat-transfer properties of the heat sink are deteriorated.

In contrast, in the case of the heat sink according to Embodiment 1 of the present invention, the protrusions 7 provided on the inner surface of the lid 10 are facilitators of turbulence in three-dimensional directions, especially in three-dimensional directions including the thickness direction of the heat sink; therefore, it is not required to produce the heat sink with a material of high heat conductivity. Moreover, in Embodiment 1 of the present invention, the larger is the draft angle of the protrusion 7, i.e., the conical angle, the more is the cooling fluid 11 likely to pass in the vicinity of the base 8, whereby the longitudinal travels (the collision and the swirling flow) are further facilitated; the heat-transfer properties are enhanced. In other words, in Embodiment 1 of the present invent.ion, instead of obtaining an effect of enhancing the heat transfer through increase in the heat-transfer area in which the base 8 and the cooling fluid 11 make contact with each other, the stirring effect is improved by use of a material that is low-cost and high-workability. Furthermore, by enlarging the draft angle of the protrusion 7 up to the range that is normally not utilized, the passage-section area in the vicinity of the base 8 is increased while improving the workability of the protrusion 7, and the cooling fluid 11 is situated to be close to the base 8, so that the heat-transfer efficiency can be enhanced. Still moreover, because the finer protrusions 7 can be provided on the inner surface of the lid 10, the heat-transfer properties are enhanced in comparison with heat sinks having a conventional structure.

Because the increase in fluid-stirring power enhances the heat-transfer properties of the heat sink, it is not required that the material of the protrusion 7 is of high heat conductivity; therefore, the flexibility in selecting of the material of the protrusion 7 is raised, and, for example, in the case where the heat sink is produced through die-casting, the draft angle can be enlarged so as to improve the workability, whereby the production is readily carried out and the production costs can be lowered.

In the figures, the heating element 6 is symbolically illustrated. The heating element 6 includes heat sources such as a heater, an electronic apparatus, and an electronic component, or the heat-radiation units and the heat exchangers of the apparatuses that transport heat from the foregoing heat sources (a heat sink similar to that of the present invention is included). The structure and the size of the heating element 6 are not limited, as long as the heating element 6 applies heat to a heat sink. In addition, the heating element 6 may be directly mounted to the base 8 through soldering or brazing, pressure welding, and the like; it may thermally be connected to the base 8 by the intermediary of a contact-thermal-resistance reduction structure such as thermal grease.

The heat-transfer container 3 serves as a container for the cooling fluid 11 and as a path through which the cooling fluid 11 travels; the heat-transfer container 3 can play roles of connecting the heating element 6 with the cooling fluid 11 and of diffusing and equalizing heat from the heating element 6. Moreover, the heat-transfer container 3 can be utilized for fixing the heating element 6 and the accompanying components. Still moreover, the heat-transfer container 3 plays, at the downstream side of the cooling-fluid inlet 1, a role of distributing the cooling fluid 11 into the flow paths 2 and equalizing the flows, and plays, at the upstream side of the cooling-fluid outlet 4, a role of merging the cooling fluids 11.

As a variant example, illustrated in FIG. 3, of Embodiment 1 of the present invent.ion, in order to facilitate the distribution of the cooling fluid 11 and the merge of the cooling fluids 11, the configuration may be in such a way that, at the downstream side, inside the heat-transfer container 3, of the cooling-fluid inlet 1, a distribution header 12 for distributing the cooling fluid 11 is provided and, at the upstream side, inside the heat-transfer container 3, of the cooling-fluid outlet 4, a merging header 13 for merging the cooling fluids 11 is provided. Additionally, only one of the distribution header 12 and the merging header 13 may be provided.

In addition, in the variant example, illustrated in FIG. 3, of Embodiment 1, the cooling-fluid inlet 1 and the cooling-fluid outlet 4 are provided at the same side (bottom left in the plane of the paper) of the heat-transfer container 3; however, they may be provided at opposite positions, for example, in such a way that one of them is situated at the bottom left of the plane of the paper and the other one is situated at the top right of the plane of the paper. In order to facilitate the flow equalization of the cooling fluid, a wire mesh, a rectification plate having slits or pores, or the like may be provided at the coupling position between the distribution header 12 or the merging header 13 and the flow path 2 so as to adjust the flow rate. Additionally, the rectification plat.e may be molded integrally with the lid 10. Additionally, a plurality of heating elements 6 may be provided on the external surface of the heat-transfer container 3; accordingly, a plurality of flow paths 2 that are parallel to one another may be provided inside the heat-transfer container 3. By providing the distribution header 12 as a distributor for the cooling fluid and the merging header 13 as a merger, further intensive cooling of a specific position of the heat-transfer container 3 or equalized cooling can efficiently be carried out.

The protrusion 7 has a role of stirring the cooling fluid 11 and, in some cases, has a role as a pillar or a reinforcement member for holding the space between the base 8 and the lid 10. In Embodiment 1, the structure of the heat sink has been explained by utilizing an example in which the protrusions 7 are provided on the inner surface of the lid 10; however, as a variant example, illustrated in FIG. 4, of Embodiment 1, the structure of the heat sink may be in such a way that the protrusions 7 are provided on the substrat.e 18 that is inserted into the heat-transfer container 3. Alternatively, the structure of the heat sink may be in such a way that the substrate 18 provided with the protrusions 7 is provided fixed inside the heat-transfer container 3.

As a result, for example, in the case where the heat sink is considerably large, mold processing such as die-casting or forging cannot be carried out in some cases, depending on pressurization performance of the processing machine; however, by dividing and diminishing the substrate 18 provided with the protrusions 7, the production of the substrate 18 can readily be performed. Moreover, by exchanging the substrate 18, the heat characteristics of the heat sink can readily be changed. Still moreover, by combining a plurality of the substrates 18. each provided with the different types of the protrusions 7, a heat sink can readily be produced in which the heat-transfer properties differ depending on positions in the flow path 2. In addition, the substrate 18 may be fixed to the heat-transfer container 3 by providing protrusions as guides in the flow path within the heat-transfer container 3; alternatively, the substrate 18 may be adhered by means of an adhesive or welded by means of a solvent to the inner surface of the heat-transfer container 3.

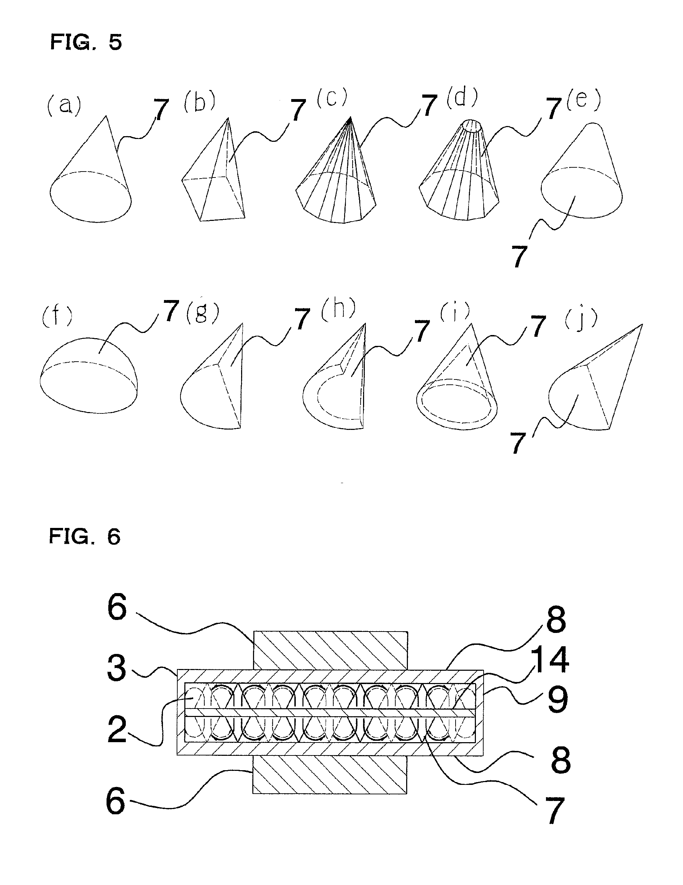

Although, in Embodiment 1 illustrated in FIGS. 1 to 4, an example has been explained in which the protrusion 7 is formed of a conical body illustrated in FIG. 5(a), the protrusion 7 may be a conical body illustrated in FIG. 5(e) or FIG. 5(i); moreover, even in the case where the protrusion 7 is an approximately conical body such as an approximate multi-sided pyramid, for example, illustrated in FIG. 5(b), FIG. 5(c), or FIG. 5(d), the same effect can be demonstrated. Moreover, even in the case where the protrusion 7 is an approximate hemisphere, illustrated in FIG. 5(f), which is generally not included in the category of a conical body, the same effect as that of a hemi-conical body can be demonstrated in the present invention. Still moreover, the protrusion 7 may be an approximately hemi-conical body, illustrated in FIG. 5(g), FIG. 5(h), or FIG. 5(j), or the like; when the cooling fluid 11 collides with the foregoing protrusions 7 in the direction from the left to the right of FIG. 5, the same effect as obtained with an approximate conical body can be demonstrated. Furthermore, the front end of the protrusion 7 may either have a sharp vertex angle illustrated in FIG. 5(a), 5(b), 5(c), 5(g), 5(h), 5(i), or 5(j) or may have a flat face illustrated in FIG. 5(d).

Moreover, the front end of the protrusion 7 may be of a spherical surface illustrated in FIG. 5(e) for 5(f); alternatively, although not illustrated, the root portion of the protrusion 7 may be formed in such a way as to have a spherical surface. Still moreover, as illustrated in FIGS. 5(h) and 5(i), the protrusion 7 may be formed in such a way as to have a hollow. Furthermore, although not illustrated, the portion, of the protrusion 7, which corresponds to the generator may be either swollen outward as a bamboo shoot or recessed. Still furthermore, as illustrated in FIG. 5(j), the protrusion 7 may not be axisymmetric.

In addition, in the case where the front end of the protrusion 7 is flat and makes contact with the inner surface of the base 8, the heat-transfer area where the inner surface of the base 8 and the cooling fluid 11 make contact with each other decreases, whereby the heat-transfer properties are deteriorated. Therefore, it is desirable that the structure of the heat sink is in such a way that the front end of the protrusion 7 is formed in such a way as to have a sharp vertex angle or a spherical surface so that the front end of the protrusion 7 makes point contact with the inner surface of the base 8. Additionally, the smaller the space between the protrusion 7 and the inner surface of the base 8 is, the more excellent the heat-transfer properties are; it is more preferable that the inner surface of the base 8 and the protrusion 7 make contact with each other.

Meanwhile, the inner surface of the base 8 and the front end of the protrusion 7 may thermally be coupled, e.g., through soldering or brazing. In that case, the front end of the protrusion 7 may not have a sharp vertex angle. In the case where the front end of the protrusion 7 and the inner surface of the base 8 are thermally coupled, the protrusion 7 demonstrates an effect as a fin; heat is transferred from the inner surface of the base 8 to the protrusion 7 and further to the lid 10, and then the heat is radiated from the outer surface of the protrusion 7 and the lid 10 to the cooling fluid 11, whereby the heat can efficiently be radiated.

Additionally, for the purpose of actively creating the three-dimensional flow of the cooling fluid 11, it is desirable that the root portion of the protrusion 7, i.e., the portion, of the protrusion 7, which makes contact with the lid 10 (in FIG. 1) or the substrate 18 (in FIG. 4) is of a spherical surface. Thus, the cooling fluid 11 gradually rises from the root of the protrusion 7, and the cooling fluid 11 collides with the inner surface of the base 8, so that the stirring of the cooling fluid 11 in the vicinity of the base 8 is facilitated.

In addition, the draft angle for the protrusion 7, i.e., the conical angle may be 1.5°; however, the conical angle of the same as or larger than 5° is preferable. The conical angle is preferably 20° or larger. That is because, in the case where the protrusion 7 is produced through die-casting and removed from the mold, the draft angle of 5° or larger enables the protrusion 7 to be extremely readily removed. Additionally, in the case where the draft angle is 20° or larger, the passage-section area in the vicinity of the base 8 is increased and the cooling fluid 11 is situated to be close to the base 8, so that the heat-transfer effect can be enhanced.

The cooling-fluid inlet 1 has a role of inputting the low-temperature cooling fluid 11; in contrast, the cooling-fluid outlet 4 has a role of outputting the high-temperature cooling fluid 11. The respective fluid-flow pipes 15 to be connected to the cooling-fluid inlet 1 and the cooling-fluid outlet 4 are formed of a circular tube, a rectangular tube, a flexible tube, a rubber-made hose, or the like. In the case where the cross section of the flow path 2 in the heat-transfer container 3 is flat, it is desirable to flatten the respective cross sections of the cooling-fluid inlet 1 and the cooling-fluid outlet 4; accordingly, it is desirable to flatten the cross section of the portion, of the fluid-flow pipe 15, which is in the vicinity of the coupling position between the fluid-flow pipe 15 and the foregoing inlet and outlet. In addit.ion, in Embodiment 1 illustrated in FIG. 1, the cooling-fluid inlet 1 and the cooling-fluid outlet 4 are provided symmetrically with each other in the sidewall of the heat sink; however, they may be provided in either the base 8 or the lid 10, or they may be provided at positions that are asymmetric with each other.

With regard to the materials that form the heat sink, it is desirable that the base 8 is made of a material having high heat conductivity; accordingly, the base 8 is formed of a metal material, having high heat conductivity, such as aluminum, copper, or an Al-Co composite material. In contrast, the sidewall 9, the lid 10, the protrusion 7, the substrate 18, and the fluid-flow pipe 15, which are the portions other than the base 8, may also be formed of a similar metal material; however, in terms of ease of molding and cost reduction, the protrusion 7 may be produced by molding a resin material. The lid 10 and the substrate 18 may also be formed through sheet-metal machining so as to reduce the costs. In this case, a recess is formed in the rear side, whereby the protrusion 7 becomes hollow; however, because the protrusion 7 is a turbulence facilitator, no problem such as deterioration in the heat characteristics exists. In addition, in consequence, weight saving can be achieved.

The cooling fluid 11 is a liquid such as distilled water, antifreeze solution, alcohol, ammonia, or ammonia water; alternatively, the cooling fluid 11 is a gas such as air, or nitrogen gas. In addition, in the present invention, when the cooling fluid is a liquid, the effect thereof is enlarged.

FIG. 6 illustrates another variant example of Embodiment 1 for a heat sink according to the present invention; The heat-transfer container 3 is provided with the respective bases 8 on the top and bottom sides thereof; on each of the bases 8, the heating element 6 is disposed. A substrate 14 is provided inside the heat-transfer container 3; on each of the top and bottom sides of the substrate 14, the protrusions7 having an approximately conical shape are provided in a predetermined arrangement. The heat sink of the variant example is configured in such a way that a pair of the heat sinks, illustrated in FIGS. 1 to 4, in each of which the heating element 6 is disposed only on one side of the heat-transfer container 3 are piled plane-symmetrically with each other by the intermediaries of the lids 10 and the two lids 10 are replaced by the substrate 14. unlike a heat sink having a configuration in which a pair of the heat sinks illustrated in FIGS. 1 to 4 are simply piled plane-symmetrically with each other, the heat sink in the variant example illustrated in FIG. 6 enables one of the cooling-fluid inlet 1 and the cooling-fluid outlet 4 to be utilized for the purpose of the other, whereby the configuration is further simplified. In the foregoing configuration, by causing a three-dimensional flow, the heat-transfer properties can be enhanced with a simplified structure; therefore, even only one heat sink enables the upper and lower (two set of) heating elements 6 to be concurrently cooled.

In addition, by providing the protrusions 7 in a predetermined arrangement on at least one side of the substrate 14, instead of providing the protrusions 7 on the both sides of the substrate 14, the cooling effect of the portion, of the heat sink, in which the protrusions 7 are provided can be enhanced. In addition, a plurality of the substrates 14 on one side of which the protrusions 7 each having an approximately conical shape are provided in a predetermined arrangement may be mounted inside the heat-transfer container in such a way that the respective surfaces, of the substrates 14, on which the protrusions 7 are not provided are brought into contact with each other.

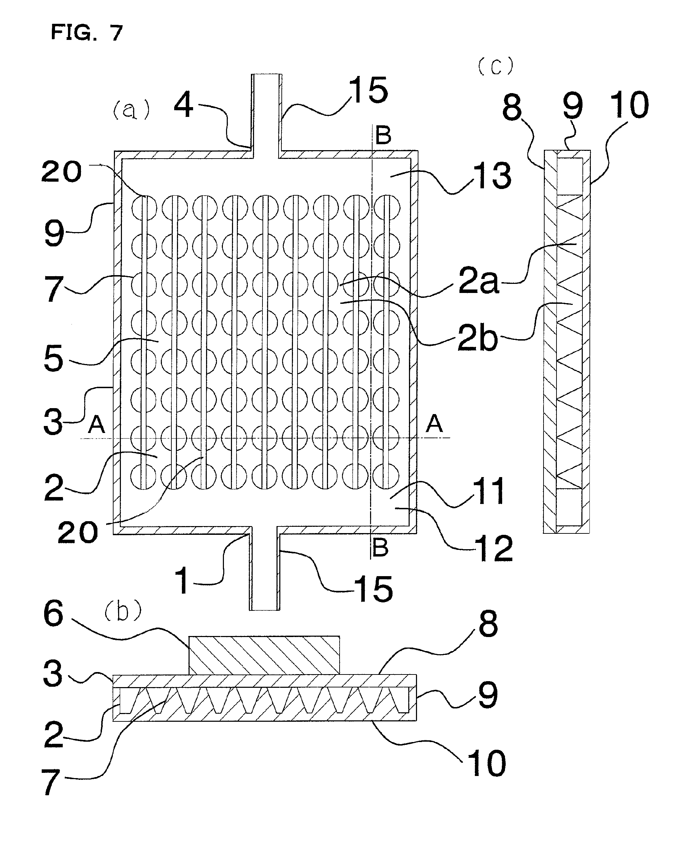

FIG. 7 illustrates a further variant example of the heat sink according to Embodiment 1 of the present invention; FIG. 7(a) is a transverse cross-sectional view; FIG. 7(b) is a longitudinal cross-sect.ional view taken along the line A - A; FIG. 7(c) is a side cross-sectional view taken along the line B - B. In FIG. 7, on the inner surface of the lid 10, a plurality of separating plates 20 extending in the direction in which the cooling fluid 11 flows is provided; the separating plates 20 separates the flow path 2 into a plurality of paths. Hemi-conical protrusions 7 as illustrated in FIG. 5(g) are provided on both sides of each of the separating plates 20. With this configuration, the flow path 2 is configured in such a way that, only in the direction in which the cooling fluid 11 flows from the cooling-fluid inlet 1 to the cooling-fluid outlet 4, a flow path 2a (including an approximately triangular flow path) whose width is diminished and a flow path 2b whose width is approximately constant are coupled in turn.

In Embodiment 1 illustrated in FIGS. 1 to 4, an example in which the protrusions 7 each having an approximately conical shape are provided in a predetermined arrangement on the inner surface of one wall, of the heat-transfer container 3, facing the wall, of the heat-transfer container 3, on which the heating element 6 is mounted, an example in which the protrusions 7 each having an approximately conical shape are provided in a predetermined arrangement on one side of the substrate 18 provided inside the heat-transfer container 3, and an example in which the substrate 14 is provided and the protrusions 7 each having an approximately conical shape are provided in a predetermined arrangement on at least one side of the substrate 14 have been explained; however, in the present invention, it is only necessary that, in the heat sink provided with the cooling-fluid inlet 1, the heat-transfer container 3 inside which the flow path 2 is formed, and the cooling-fluid outlet 4, the flow path 2 is configured in such a way that the approximately trapezoidal flow path 2a (including an approximately triangular flow path) whose width decreases, in the longitudinal direction of the heat-transfer container 3, from the vicinity of the place where the heating element 6 is mounted and a flow path 2b whose width is approximately constant are coupled in turn; thus, the variant example illustrated in FIG. 7 can also demonstrate the same effect.

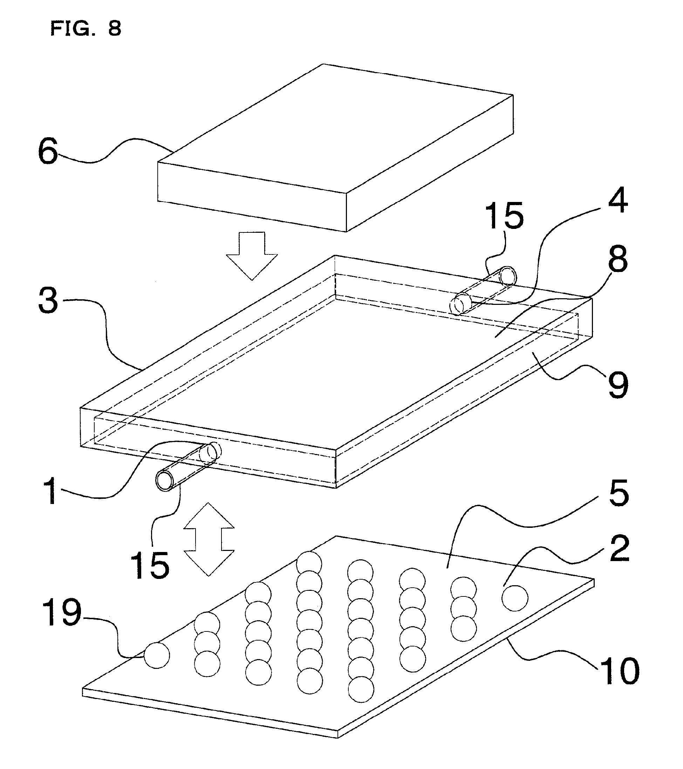

FIG. 8 is a further variant example of the heat sink according to Embodiment 1 of the present invention. In FIG. 8, a plurality of turbulence facilitators 19 each having an approximately spherical shape is mounted on the inner surface of the lid 10 of the heat-transfer container 3. This variant example is configured in such a way that a flow path whose width changes, in the longitudinal direction of the heat-transfer container 3, from the vicinity of the place where the heating element 6 is mounted and a flow path whose width is approximately constant are coupled in turn; thus, the same effect as that of each of other examples can be demonstrated.

In addition, a recess may be provided in the inner surface of at least one side of the flow path 2 in order to facilitate the positioning of the turbulence facilitator 19. Additionally, the turbulence facilitator 19 may thermally be coupled with at least one surface of the flow path 2, e.g., through soldering or brazing. When being thermally coupled with the surface of the wall, of the heat-transfer container 3, on which the heating element 6 is provided, the turbulence facilitator 19 demonstrates an effect of a fin; heat is transferred through heat conduction from the inner surface to the turbulence facilitator 19 and the heat is radiated from the outer surface of the turbulence facilitator 19 to the cooling fluid 11, whereby the heat can efficiently be radiated.

When the turbulence facilitator 19 is thermally coupled with the inner surfaces of both sides, in the flow path, of the heat-transfer container 3, heat is transferred through heat conduction from the inner surface of the heat-transfer container 3 to the turbulence facilitator 19 and further to the lid 10; thus, the heat is radiated from the outer surface of the turbulence facilitator 19 and the lid 10 to the cooling fluid 11, whereby the heat can further efficiently be radiated. The turbulence facilitators 19 may be spaced apart from one another or may make contact with one another. Moreover, the turbulence facilitator 19 may be a hollow sphere; the material of the turbulence facilitator 19 may be of high heat conductivity, as is the case with the protrusion 7, or a material, such as a resin, of low heat conductivity.

In the foregoing cases, in the cross section, of the flow path 2, perpendicular to the flow direction, a portion that narrows in proportion to the distance from the side on which the heating element 6 is mounted and a portion in which the width of the flow path 2 is constant are also formed alternately. In addition, the flow path 2 is configured in such a way that approximately trapezoidal flow paths the width of each of which gradually decreases, in the height direction (thickness direction) of the heat-transfer container 3, from the side on which the heating element 6 is mounted and flow paths the width of each of which is approximately constant are sequentially coupled.

### Embodiment 2

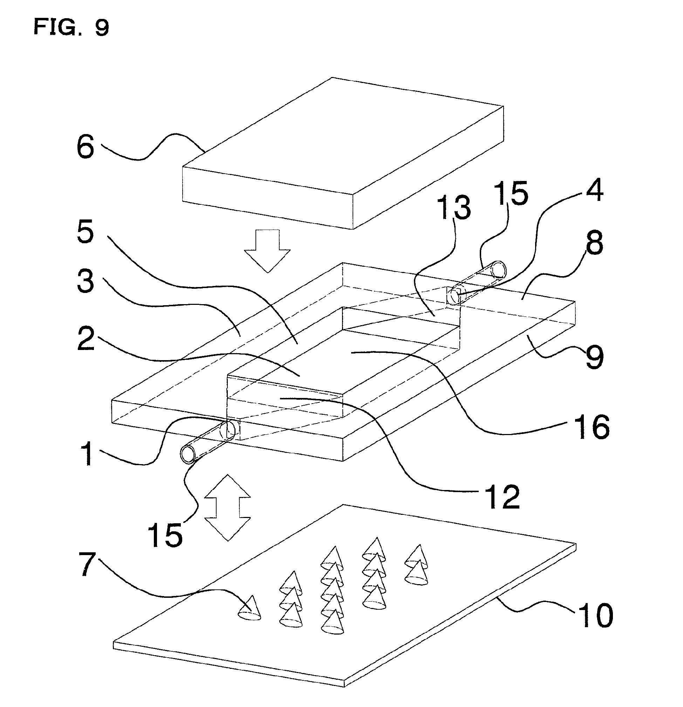

FIG. 9 is an exploded perspective view symbolically illustrating a heat sink according to Embodiment 2 of the present invention. As illustrated in FIG. 9, as the heat-transfer container 3, a heat-transfer container is utilized which has an opening 16 in its side on which the heating element 6 is mounted. Other configurations are the same as those of Embodiment 1; therefore, explanations therefor will be omitted.

According to Embodiment 2, unlike Embodiment 1, the heat-transfer container 3, as illustrated in FIG. 9, has an opening in its side on which the heating element 6 is mounted; by mounting the heating element 6, the opening is covered and a flow path is formed. In other words, by providing the heating element 6 so as to cover the opening 16, the flow path 2 is formed; the heat sink is configured in such a way that the mounting side for the heating element 6 directly makes contact with the cooling fluid 11 and heat is directly transferred to the cooling fluid 11. Accordingly, in this case, the fluid-flow path 5 and the flow path 2 are formed with the cooling-fluid inlet 1, the heat-transfer container 3, the cooling-fluid outlet 4, and the heating element 6. In consequence, the contact thermal resistance between the heating element 6 and the base 8 and the thermal resistance of the base 8 can be eliminated, whereby the heat characteristics of the heat sink can be enhanced.

In Embodiment 2, without providing any fin in the heating element 6, the heat transfer between the heating element 6 and the cooling fluid 11 is enhanced through turbulence facilitation effects of the protrusions 7 provided on the lid 10, whereby the radiation characteristics are enhanced. As described above, because no fin is directly provided in the heating element 6, the heating element 6 of an electronic apparatus, a power module, or the like is readily produced, whereby the costs can be lowered. Moreover, even in the case where the amount of heat generated by the heating element 6 changes depending on usage conditions, the radiation characteristics can be changed by changing the shapes, the sizes, the arrangement pitch, or the like of the protrusions 7 provided on the lid 10. Still moreover, because it is not required to change the structure of the heating element 6 itself, the heating element 6 can be produced so as to be universal, whereby the convenience is enhanced and the costs of the overall system can be reduced.

In addition, the coupling between the heating element 6 and the heat-transfer container 3 can be carried out through pressure-bonding utilizing an O-ring or a gasket or through adhesion utilizing an adhesive.

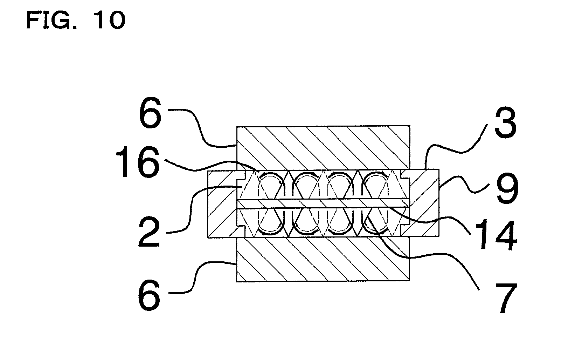

Moreover, as illustrated in FIG. 10, the structure of the heat sink may be in such a way that the opening 16 is provided in each of both sides of the heat-transfer container 3 and the substrate 14 on both sides of which the protrusions 7 are provided is inserted into the flow path 2 in the heat-transfer container 3. The substrate 14 is provided in the heat-transfer container 3, and the protrusions 7 each having an approximately conical shape are provided in a predetermined arrangement on both sides of the substrate 14, so that two heating elements can be cooled with a single heat sink. In addition, by providing the protrusions 7 in a predetermined arrangement on at least one side of the substrate 14, instead of providing the protrusions 7 on the both sides of the substrate 14, the cooling effect of the portion, of the heat sink, in which the protrusions 7 are provided can be enhanced.

### Embodiment 3

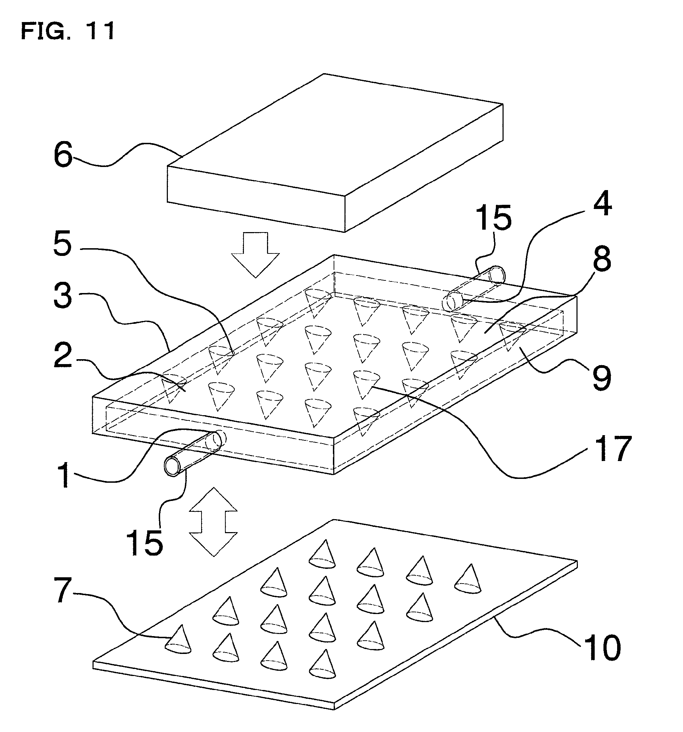

FIG. 11 is an exploded perspective view symbolically illustrating a heat sink according to Embodiment 3 of the present invention. In FIG. 11, conical pin fins 17 are arranged on the inner surface of the base 8 that makes contact with the heating element 6. Additionally, the protrusions 7 each having a conical shape similar to that of the pin fin 17 are provided on the inner surface of the lid 10. As illustrated in FIG. 11, the pin fins 17 are arranged on a grid, the protrusions 7 arranged on a grid in such a way as to avoid the pin fins 17 are provided on the lid 10, and the base 8 and the lid 10 are combined, so that a structure is formed in which the pin fins 17 and the protrusions 7 form a staggering arrangement. Accordingly, pins in a staggering arrangement, which are generally difficult to machine can readily be produced. In addition, the heat-transfer area decreases in comparison with a heat sink in which pin fins are provided in a staggering arrangement on the heat transfer surface; however, even in the case of Embodiment 3, a three-dimensional flow is produced in the cooling fluid 11, whereby the heat transfer on the heat-transfer surface is enhanced; therefore, the heat characteristics becomes relatively high. On the contrary, because the number of the pin fins 17 to be mounted is halved, pin fins 17 and protrusions 7 can be arranged further in a sparse manner; by combining the pin fins 17 and the protrusions 7, densification is enabled, whereby the heat-transfer properties can be enhanced.

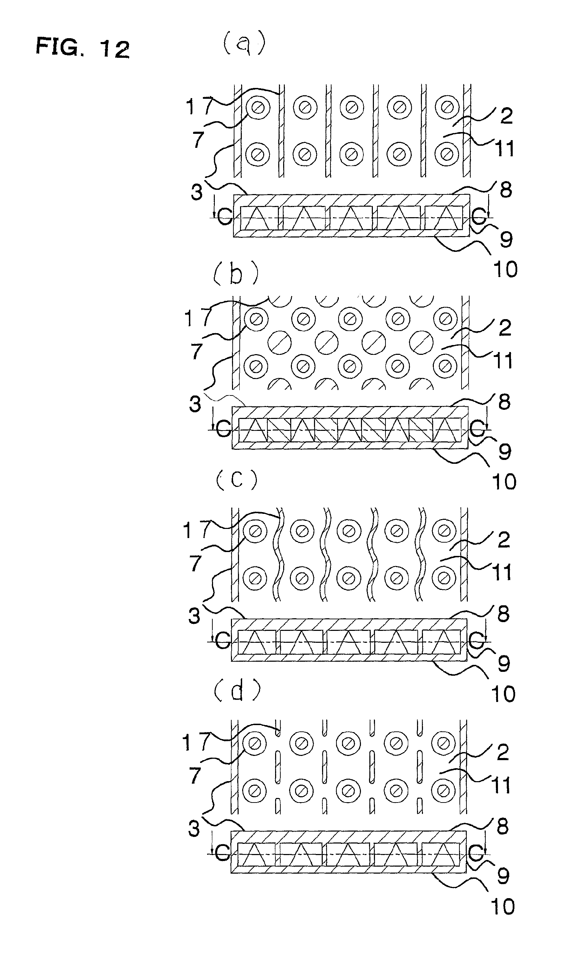

FIG. 12 is a flow path cross-sectional view symbolically illustrating a heat sink that is a variant example of Embodiment 3; FIGS. 12(a), 12(b), 12(c), and 12(d) illustrate respective variant examples. In each of FIGS. 12(a), 12(b), 12(c), and 12(d), the upper figure illustrates a longitudinal cross section, and the lower figure illustrates the transverse cross section taken along the line C - C. With regard to the variant examples in FIG. 12, FIGS. 12(a), 12(b), 12(c), and 12(d) illustrate a case where a plurality of tabular straight fins is provided on the inner surface of the base 8, along the flow of the cooling fluid 11; a case where a plurality of pin fins 17 is provided on the inner surface of the base 8; a case where a plurality of wavy fins, heliborne fins, or serrated fins 17 is provided on the inner surface of the base 8, along the flow of the cooling fluid 11; and a case where a plurality of offset fins or porous plate fins 17 is provided on the inner surface of the base 8, along the flow of the cooling fluid 11, respectively.
In addition, with the heating element 6 disposed in an opening provided in the heat-transfer container 3, the foregoing fins 17 may be provided on the heat-transfer surface, of the heating element 6, which makes contact with the cooling fluid 11.

In the heat sink according to Embodiment 3, the fins 17 are provided in Embodiment 1 or in Embodiment 2 so as to enlarge the heat-transfer area; thus, the heat-transfer properties can be enhanced.

### Industrial Applicability

A heat sink according to the present invention can be utilized as a cooling device for cooling a heating element such as an electronic component in an electronic apparatus.

### Brief Description of the Drawings

FIG. 1 is an exploded perspective view symbolically illustrating a heat sink according to Embodiment 1;
FIG. 2 is a cross-sectional view symbolically illustrating a heat sink according to Embodiment 1;
FIG. 3 is an exploded perspective view symbolically illustrating a heat sink that is a variant example of Embodiment 1;
FIG. 4 is an exploded perspective view symbolically illustrating a heat sink that is another variant example of Embodiment 1;
FIG. 5 is a perspective view symbolically illustrating protrusions for a heat sink that is another variant example of Embodiment 1;
FIG. 6 is a cross-sectional view symbolically illustrating a heat sink that is another variant example of Embodiment 1;
FIG. 7 is a cross-sectional view symbolically illustrating a heat sink that is another variant example of Embodiment 1;
FIG. 8 is an exploded perspective view symbolically illustrating a heat sink that is another variant example of Embodiment 1;
FIG. 9 is an exploded perspective view symbolically illustrating a heat sink according to Embodiment 2;
FIG. 10 is a cross-sectional view symbolically illustrating a heat sink that is a variant example of Embodiment 2;
FIG. 11 is a perspective view symbolically illustrating a heat sink according to Embodiment 3; and
FIG. 12 is a flow path cross-sect.ional view symbolically illustrating a heat sink that is a variant example of Embodiment 3.

### [Description of Symbols]

1: cooling-fluid inlet
2, 2a, and 2b: flow path
3: heat-transfer container
4: cooling-fluid outlet
5: fluid-flow path
6: heating element
7: protrusion
8: base
9: sidewall
10: lid
11: cooling :fluid
12: distribution header
13: merging header
14 and 18: substrate
15: fluid-flow pipe
16: opening
17: fin
19: turbulence facilitator

## Claims

1. A heat sink, provided with a heat-transfer container incorporating a flow path through which a cooling fluid flows, for cooling a heating element in contact with the heat-transfer container, by means of the cooling fluid that flows through the flow path,
wherein the flow path includes a first cross-sectional portion that becomes narrower as the distance between a given point therein and a side, of the heat-transfer container, which makes contact with the heating element becomes longer in a direction perpendicular to the direction in which the cooling fluid flows and a second cross-sectional portion that is approximately constant in the direction perpendicular to the direction in which the cooling fluid flows, and the first cross-sectional portion and the second cross-sectional portion alternately continue in the direction in which the cooling fluid flows.

2. The heat sink according to claim 1, wherein the shape of the first cross-sectional portion is formed based on one or more protrusions provided inside the heat-transfer container.

3. The heat sink according to claim 2, wherein the protrusion has at least one of the shapes of an approximate cone, an approximate multi-sided pyramid, an approximate sphere, and a hemisphere.

4. The heat sink according to any one of claims 1 to 3, wherein a fin extending in the direction in which the cooling fluid flows is provided on the inner surface of the heat-transfer container.

5. The heat sink according to any one of claims 2 and 3, wherein the protrusions are arranged in plurality on a substrate provided in the heat-transfer container.

6. The heat sink according to claim 5, wherein the substrate is disposed inside the heat-transfer container in such a way as to divide the flow path into two flow paths, the protrusions are arranged on both sides of the substrate, and the heat-transfer container is configured in such a way that a side thereof in contact with one of the divided flow paths and a side thereof in contact with the other of the divided flow paths make contact with respective heating elements.

7. A heat sink, provided with a heat-transfer container having a flow path through which a cooling fluid flows, for cooling a heating element in contact with the heat-transfer container, by means of the cooling fluid that flows through the flow path, wherein the heat-transfer container has an opening for bringing the cooling fluid into direct contact with the heating element.; the flow path includes a first cross-sectional portion that becomes narrower as the distance between a given point therein and a side, of the heat-transfer container, which makes contact with the heating element becomes longer in a direction perpendicular to the direction in which the cooling fluid flows and a second cross-sectional portion that is approximately constant in the direction perpendicular to the direction in which the cooling fluid flows; and the first cross-sectional portion and the second cross-sectional portion alternately continue in the direction in which the cooling fluid flows.

8. The heat sink according to claim 7, wherein a fin extending in the direction in which the cooling fluid flows is provided on a side, of the heating element, which makes contact with the cooling fluid.
